Europäisches Patentamt

European Patent Office

Office européen des brevets

(19)

(11) **EP 0 350 397 B1**

(12) **FASCICULE DE BREVET EUROPEEN**

(45) Date de publication et mention
de la délivrance du brevet:
**04.03.1998 Bulletin 1998/10**

(51) Int Cl.⁶: **H01J 37/305**

(21) Numéro de dépôt: **89401924.9**

(22) Date de dépôt: **05.07.1989**

(54) **Evaporateur à bombardement électronique muni de moyens de récuperation des électrons rétrodiffusés**

Mit Mitteln zur Wiedererlangung von Rückstreu-Elektronen versehene
Elektronenbombardierungs-Verdampfungsvorrichtung

Electron bombardment evaporator with back scattered electron recuparating means

(84) Etats contractants désignés:
**DE GB**

(30) Priorité: **06.07.1988 FR 8809156**

(43) Date de publication de la demande:
**10.01.1990 Bulletin 1990/02**

(73) Titulaire: **COMMISSARIAT A L'ENERGIE
ATOMIQUE**
**75015 Paris Cédex 15 (FR)**

(72) Inventeur: **Lizee, Jean-François**
**F-75015 Paris (FR)**

(74) Mandataire: **Dubois-Chabert, Guy et al**
**c/o BREVATOME**
**25, rue de Ponthieu**
**75008 Paris (FR)**

(56) Documents cités:
**US-A- 3 467 057          US-A- 3 949 187**
**US-A- 4 262 160**

- **THIN SOLID FILMS, vol. 110, no. 2, décembre
1983, pages 149-164, Elsevier**
- **Sequoia, Lausanne, CH; S. SCHILLER et al.:
"High rate electron beam evaporation"**

## Description

La présente invention a pour objet un évaporateur à bombardement électronique muni de moyens de récupération des électrons rétrodiffusés.

Dans un évaporateur à bombardement électronique, une cible (du métal le plus souvent) est chauffée sous l'impact d'un faisceau d'électrons.

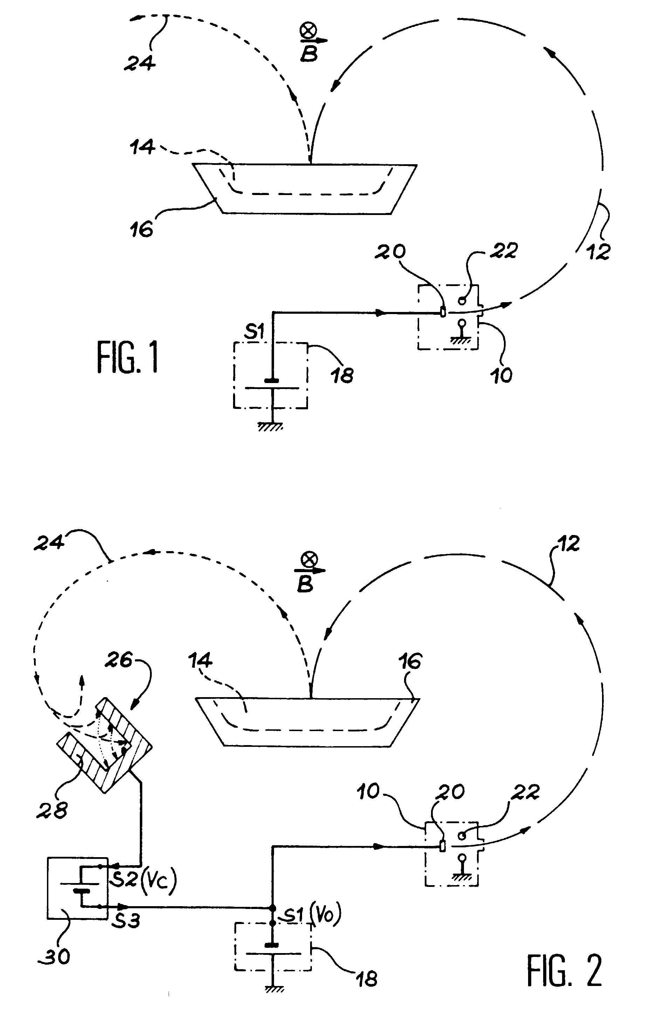

Comme on le voit sur la figure 1, un évaporateur comporte un canon à électrons 10 émettant un jet d'électrons 12 accélérés sous quelques dizaines de kilovolts. Une alimentation continue 18 engendre sur une sortie S1 une différence de potentiel appliquée entre la cathode 20 et l'anode 22 du canon à électrons 10. La trajectoire du faisceau 12 est courbée par un champ magnétique $\vec{B}$ de quelques $10^{-3}$ Tesla (c'est-à-dire quelques dizaines de Gauss). Le faisceau 12 ainsi dirigé frappe la cible 14 contenue dans un creuset 16 et ainsi l'échauffe jusqu'à sa température d'évaporation.

Dans des conditions usuelles d'utilisation, l'alimentation 18 fournit un courant Io de 10A pour une tension Vo de -30 kV entre cathode 20 et anode 22 par exemple. Le faisceau d'électrons 12 irradiant la cible 14 possède alors une puissance incidente Po de 300 kW. Mais cette puissance incidente Po n'est pas entièrement consommée par l'échauffement de la cible 14. En particulier, une partie de la puissance Po est perdue sous forme de réémission par la cible 14 d'électrons dits secondaires 24.

Ces électrons secondaires sont de deux types :

- les électrons secondaires vrais, formant une émission de surface caractérisée par une faible énergie (inférieure à 50 eV),
- les électrons rétrodiffusés, dûs à des chocs élastiques à l'intérieur de la cible 14 ; ils sont comparables à des électrons réfléchis par la cible 14.

Les trajectoires 24 de ces électrons secondaires sont elles aussi courbées par le champ magnétique $\vec{B}$. Le spectre en énergie et la répartition dans l'espace de ces électrons secondaires dépendent essentiellement de trois paramètres : l'énergie du faisceau incident 12, l'angle incident et le numéro atomique de la cible 14.

Le but de la présente invention est de récupérer une fraction de l'énergie portée par ces électrons secondaires de type rétrodiffusés afin de la réutiliser dans le processus de bombardement.

De manière plus précise, la présente invention concerne un évaporateur à bombardement électronique muni de moyens de récupération des électrons rétrodiffusés par une cible soumise à un bombardement par un faisceau électronique, ce dernier provenant d'un canon à électrons dont une électrode est reliée à une sortie (S1) d'une première alimentation continue, cette première alimentation fournissant un potentiel Vo négatif par rapport au potentiel de la cible sur sa sortie (S1), comprenant :

- des moyens pour collecter lesdits électrons rétrodiffusés, ces moyens étant portés à un potentiel Vc négatif inférieur en valeur absolue à Vo,
- une seconde alimentation continue reliée par une première sortie (S2) aux moyens pour collecter les électrons rétrodiffusés, cette première sortie (S2) étant portée au potentiel Vc, la seconde alimentation étant en outre reliée par une seconde sortie (S3) à la sortie (S1) de la première alimentation, la seconde sortie (S3) étant portée au potentiel Vo.

De manière préférée, les moyens pour collecter lesdits électrons rétrodiffusés consistent en une cage de piégeage métallique récupérant tout électron dû à une rétrodiffusion survenant à l'intérieur de ladite cage.

La forme de cette cage de piégeage est adaptée à la forme du jet des électrons rétrodiffusés par la cible. Elle peut être cylindrique ou parallélépipédique.

De manière préférée, pour un canon à électrons linéaire la cage de piégeage est parallélépipédique, une ouverture étant ménagée dans la cage pour permettre l'introduction du jet d'électrons rétrodiffusés.

Les caractéristiques et avantages de l'invention apparaîtront mieux après la description qui suit, donnée à titre explicatif et nullement limitatif. Cette description se réfère à des dessins annexés sur lesquels :

- la figure 1, déjà décrite, représente schématiquement un évaporateur à bombardement électronique,
- la figure 2 représente schématiquement ce même évaporateur muni d'un dispositif conforme à l'invention,
- la figure 3 représente schématiquement les variations de la puissance Pc récupérée par un dispositif selon l'invention en fonction du potentiel Vc,
- la figure 4 représente schématiquement une cage de piégeage vue en perspective.

La figure 2 représente schématiquement un évaporateur muni d'un dispositif conforme à l'invention.

Les trajectoires 24 des électrons secondaires émis par la cible 14 sont courbés sous l'effet du champ magnétique appliqué $\vec{B}$. Sur ces trajectoires 24, on place des moyens 26 pour collecter les électrons "secondaires". Préférentiellement, ces moyens 26 sont formés d'une cage de piégeage 28 métallique portée à un potentiel Vc. On peut utiliser par exemple, une cage en cuivre refroidie par une circulation d'huile.

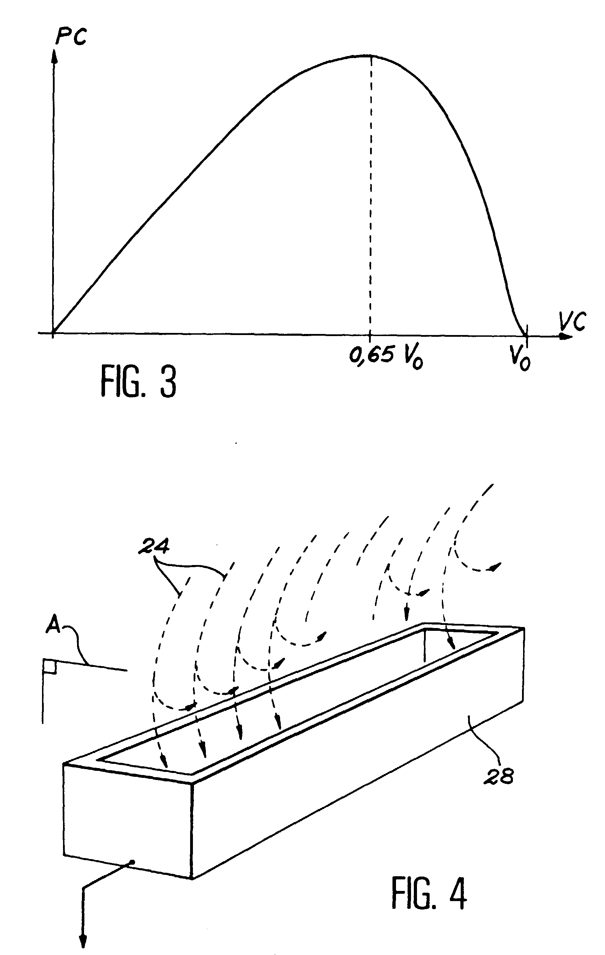

La figure 3 représente schématiquement les variations de la puissance Pc récupérée par un dispositif selon l'invention en fonction de la valeur de Vc. On constate que cette puissance Pc présente dans cet exemple un maximum pour une valeur de Vc égale sensiblement à 0,65 Vo.

Dans les conditions usuelles de fonctionnement, cette valeur est telle que seuls les électrons rétrodiffusés sont captés par la cage de piégeage 28. Les électrons "secondaires vrais" de faible énergie sont repoussés par la cage de piégeage 28.

Généralement, dans un évaporateur, le bombardement électronique est effectué sous forme de nappe. Le faisceau 12 d'électrons frappe donc la cible 14 le long d'une bande ; l'efficacité de l'échauffement est alors accrue puisque les électrons sont répartis sur la cible 14. Les électrons secondaires sont aussi renvoyés sous la forme d'une nappe. La cage de piégeage 28, pour capturer tous les électrons de la nappe, a la forme d'un parallélépipède rectangle par exemple.

La figure 4 représente schématiquement la cage de piégeage 28 en perspective. La nappe des électrons rétrodiffusés est attirée alors que les électrons secondaires vrais sont repoussés. Pour en revenir à la figure 2, on voit la cage de piégeage 28 en coupe suivant le plan A. Une alimentation 30 est reliée par une première sortie S2 à la cage de piégeage 28. Cette sortie S2 est portée au potentiel Vc. Une seconde sortie S3 de cette alimentation 30 est reliée à la sortie S1 de l'alimentation 18. Cette seconde sortie S3 est donc portée au potentiel Vo qui fait office de potentiel de référence.

La puissance récupérée Pc par le dispositif selon l'invention n'est pas égale à la puissance effective Pe des électrons rétrodiffusés capturés par la cage de piégeage. De cette dernière on doit soustraire la puissance de freinage Pf dépensée par les électrons à l'arrivée dans la cage de piégeage 28. La puissance récupérée Pc par le dispositif est donc égale à Pe-Pf.

A l'intérieur même de la cage de piégeage 28, il se produit aussi une émission d'électrons secondaires. Mais tous ces électrons sont piégés à l'intérieur de la cage de piégeage 28, d'une part sous l'effet du champ magnétique appliqué $\vec{B}$, d'autre part grâce à la géométrie de la cage de piégeage 28.

Exemple :

Puissance incidente sur la cible Po = 300 kW.
Puissance des électrons rétrodiffusés (perdue pour l'échauffement de la cible) PR = 111 kw.

Cette puissance correspond à un coefficient de rétrodiffusion CR = 0,5.

Intensité des électrons rétrodiffusés IR = 5A.
Puissance des électrons non collectés par le dispositif = 17 kW.
Puissance incidente efficace des électrons capturés par la cage de piégeage Pe = 94 kW.
Puissance de freinage perdue par les électrons piégés Pf = 22 kW.
Puissance récupérée PC = 72 kW.
Intensité correspondant à la puissance récupérée : IC = 3,7 A
Puissance fournie par l'alimentation 30 : 39 kW
Puissance débitée sur la seconde sortie S3 de l'alimentation 30 sur la sortie S1 de l'alimentation 18 reliée à la cathode du canon à électrons : PC + 39 kW = 111kW
Intensité délivrée par la seconde sortie S3 de l'alimentation 30 : IC = 3,7A.
Sortie S2 de l'alimentation 30 portée au potentiel : Vc = -19,5 kV.
Sortie S3 de l'alimentation 30 portée au potentiel : Vo = -30 kV.

On constate sur cet exemple que 72 kW des 111 kW perdus pour l'échauffement de la cible peuvent être récupérés. L'alimentation 30 fournissant le complément (39 kW), on peut réutiliser la puissance totale (111 kW) perdue dans le processus d'évaporation.

Si l'alimentation 30 doit fournir de la puissance, seule l'intensité récupérée par la cage de piégeage (IC = 3,7A) est renvoyée sur la sortie S1 de l'alimentation principale 18. Cet apport d'intensité permet de soulager l'alimentation principale qui ne doit fournir que 6,3A pour que 10A environ soient délivrés sur la cathode 20. L'alimentation principale 18 ne doit dépenser que 189 kW pour qu'un faisceau d'électrons 12 d'une puissance Po = 300 kW soit envoyé sur la cible. L'intérêt d'un dispositif selon l'invention apparaît donc clairement.

**Revendications**

1. Evaporateur à bombardement électronique muni de moyens de récupération des électrons rétrodiffusés par une cible (14) soumise à un bombardement par un faisceau électronique (12), ce dernier provenant d'un canon à électrons (10) dont une électrode (20) est reliée à une sortie S1 d'une première alimentation continue (18), cette première alimentation (18) fournissant un potentiel Vo négatif sur sa sortie (S1), comprenant :

   - des moyens (26) pour collecter lesdits électrons rétrodiffusés, ces moyens (26) étant portés à un potentiel Vc tel que les électrons rétrodiffusés par la cible (14) sont attirés par lesdits moyens (26),
   - une seconde alimentation continue (30) reliée par une première sortie (S2) aux moyens (26) pour collecter les électrons rétrodiffusés, cette première sortie (S2) étant portée au potentiel Vc, la seconde alimentation (30) étant en outre reliée par une seconde sortie (S3) à la sortie (S1) de la première alimentation (18), la seconde sortie (S3) étant portée au potentiel Vo.

2. Evaporateur selon la revendication 1, les moyens (26) pour collecter lesdits électrons rétrodiffusés consistant en une cage de piégeage (28) métallique récupérant tout électron dû à une rétrodiffusion survenant à l'intérieur de ladite cage.

**3.** Evaporateur selon la revendication 2, la cage de piégeage (28) étant parallélépipédique.

## Patentansprüche

**1.** Mit Mitteln zur Wiedererlangung von Elektronen versehene Elektronenbombardierungs-Verdampfungsvorrichtung, die durch ein mit einem Elektronenstrahl (12) beschossenes Target (14) rückgestreut werden, wobei dieser Elektronenstrahl von einer Elektronenkanone (10) stammt, deren eine Elektrode (20) mit einem Ausgang S1 einer ersten Gleichstromversorgung (18) verbunden ist und diese Gleichstromversorgung (18) an ihrem Ausgang (S1) ein negatives Potential Vo liefert, umfassend:

- Einrichtungen (26) zum Sammeln der genannten rückgestreuten Elektronen, wobei diese Einrichtungen (26) auf ein Potential Vc gebracht werden, so daß die durch das Target (14) rückgestreuten Elektronen von dem genannten Einrichtungen (26) angezogen werden,
- eine zweite Gleichstromversorgung (30), durch einen ersten Ausgang (S2) mit Einrichtungen (26) zum Sammeln der rückgestreuten Elektronen verbunden, wobei dieser erste Ausgang (S2) auf das Potential Vc gebracht wird, die zweite Gleichstromversorgung (30) außerdem durch einen zweiten Ausgang (S3) mit dem Ausgang (S1) der ersten Versorgung (18) verbunden ist und der zweite Ausgang (S3) auf das Potential Vo gebracht wird.

**2.** Verdampfungsvorrichtung nach Anspruch 1, dadurch gekennzeichnet, daß die Einrichtungen (26) zum Sammeln der rückgestreuten Elektronen durch einen metallischen Fangkäfig (28) gebildet werden, der jedes aufgrund einer Rückstreuung ins Innere des besagten Käfigs eintretende Elektron einfängt.

**3.** Verdampfungsvorrichtung nach Anspruch 2, wobei der Fangkäfig 28 parallelflach bzw. quaderförmig ist.

## Claims

**1.** Electron bombardment evaporator provided with means for recovering electrons backscattered by a target (14) subjected to a bombardment by an electron beam (12), said beam originating from an electron gun (10) with an electrode (20) connected to an output S1 of a first d.c. power source (18), said power source (18) furnishing a negative potential Vo on its output S1, comprising:

- means (26) to collect said backscattered electrons, said means (26) being brought to a potential Vc such that the electrons backscattered by the target (14) are attracted by said means (26),
- a second d.c. power source (30) connected via a first output (52) to the means (26) to collect the backscattered electrons, this second output (S2) being brought to the potential Vc, the second power source (30) being also connected via a second output (S3) to the output (S1) of the first power source (18), the second output (S3) being brought to the potential Vo.

**2.** Evaporator according to claim 1, the means (26) to collect said backscattered electrons comprising a metal trapping cage (28) recuperating any electron due to a backscattering occurring inside said cage.

**3.** Evaporator according to claim 2, the trapping cage being parallelepipedic.

FIG. 1

FIG. 2

EP 0 350 397 B1

FIG. 3

FIG. 4

6